# EUROPEAN PATENT APPLICATION

(11) **EP 4 044 226 A1**
(43) Date of publication of application: **17.08.2022**
(21) Application number: 21157363.9
(22) Date of filing: 16.02.2021
(51) Int. Cl.: H01L 23/495, H01L 23/31

(54) **A SEMICONDUCTOR DEVICE AND A METHOD OF MANUFACTURING OF A SEMICONDUCTOR DEVICE**

(71) Applicant: Nexperia B.V., 6534 AB Nijmegen (NL)
(72) Inventor: Chau, On Lok, 6534AB Nijmegen (NL); Wong, Fei, 6534AB Nijmegen (NL); Hor, William, 6534 AB Nijmegen (NL); Bi, Billie, 6534AB Nijmegen (NL); Shiu, Ivan, 6534AB Nijmegen (NL)
(74) Representative: Pjanovic, Ilija

(57) **Abstract**

This present invention relates to a semiconductor device comprising a lead frame, a metal pad, wherein the metal pad is connected to a back side of the semiconductor device via the lead frame. The semiconductor device further comprises a die pad, wherein the die pad is attached to the lead frame via a die attach material, and an encapsulant that is disposed on the top surface of the lead frame. The encapsulant isolates the metal pad from the die pad.

## Description

### FIELD

The present invention relates to a semiconductor device. The invention also relates to a method of manufacturing of a semiconductor device.

### BACKGROUND

Power quad-flat no-leads (QFN) or power dual-flat no-leads (DFN) packages are known in the art. A typical power QFN package comprises a power die and a QFN structure with external terminals protruding downwards. A lead frame die pad can be exposed as a thermal pad for connection to a printed circuit board (PCB). An interconnect between the power die and terminals are typically wire bonding or clip bonding. Such an interconnect introduces an additional resistance and inductance which negatively affects the electrical performance of the final product.

It is also known in the art that the power die pads can be exposed as terminals. US9214416B1 patent discloses a power QFN/DFN with exposed die pads and molded surfaces. This patent describes a power DFN and a power QFN package architecture that accommodates a bump-chip die and other components in cavities on the bottom-side of the matrix leadframe. This technique is also applicable to laminated substrate packages like the ball grid array (BGA) and land grid array (LGA).

Such a is suited for high speed power compound semiconductor devices like GaN and SiC. The package enables single and multiple power switch configurations, and well controlled paralleling of high speed power die switches. It enables co-packaging of associated components like cascoded switches, gate drivers, isolators and protection devices, which must be tightly coupled at high switching speeds.

The architecture accommodates components on the top-side of the leadframe as well allowing for multi-chip functions with extremely low interconnect inductance and resistance, and higher circuit and power densities.

The package architecture provides for lower package thermal resistance with parallel thermal paths from both sides of power die to the external bottom-side pads, and supplementary isolated and non-isolated top-side heat dissipation.

An disadvantage of such package architecture is that the lead frame structure must use molding for encapsulation, in which the terminal height alignment becomes a critical manufacturing challenge, and the manufacturing complexity is significantly increased since an additional design and process are needed.

### SUMMARY

Various example embodiments are directed to the disadvantage as described above and/or others which may become apparent from the following disclosure.

According to an embodiment of this invention a semiconductor device comprises a lead frame, a metal pad, wherein the metal pad is connected to a back side of the semiconductor device via the lead frame. The semiconductor device further comprises a die pad, wherein the die pad is attached to the lead frame via a die attach material. An encapsulant is disposed on the top surface of the lead frame, wherein the encapsulant isolates the metal pad from the die pad.

The lead frame acts as a heat sink.

The lead frame can be pre-plated with an appropriate surface finish, such as NiPdAu.

The die attach material can be a conductive die attach film, a silver epoxy or a sintering material.

The present invention also relates to a method of producing a semiconductor device, wherein the method comprises steps:
- forming a metal pad on a top side of a lead frame;
- attaching a die pad via a die attach material to the lead frame;
- dispensing an encapsulant on the top of the lead frame, wherein the encapsulant isolates the metal pad from the die pad; and
- singulating a semiconductor device.

The method can further comprise a step of deflash so to remove the encapsulant from the metal pad and from the die pad.

The new leadless lead frame package according to the embodiments of the present invention further miniaturizes two-terminal DFN packages, which is very advantageous. Using the lead frame structure as one interconnect to the die, so that conventional wire bond or clip bond, as known in the art, can be eliminated. Furthermore, the electrical performance of the semiconductor device is improved due to reduced resistance and inductance. The top heat sink feature provides enhanced thermal performance, and the lead frame pad construction also serves as a good transient thermal buffer. The lead frame block design can support molding or jet dispensing of encapsulant, and conventional taping of QFN/DFN lead frame is not required.

The embodiments of the present invention provide further miniaturization of the semiconductor device. As compared to chip scale package such as DSN, the new package is 5-side protected and support higher power due to vertical current flow.

### DESCRIPTION OF THE DRAWINGS

So that the manner in which the features of the present disclosure can be understood in detail, a more particular description is made with reference to embodiments, some of which are illustrated in the appended figures. It is to be noted, however, that the appended figures illustrate only typical embodiments and are therefore not to be considered limiting of its scope. The figures are for facilitating an understanding of the disclosure and thus are not necessarily drawn to scale. Advantages of the subject matter claimed will become apparent to those skilled in the art upon reading this description in conjunction with the accompanying figures, in which like reference numerals have been used to designate like elements, and in which:
Figure 1 illustrates a semiconductor device according to an embodiment of the invention;
Figure 2 illustrates a semiconductor device according to an embodiment of the invention;
Figure 3 illustrates a method of manufacturing of a semiconductor device according to an embodiment of the invention;
Figure 4 illustrates a semiconductor device according to an embodiment of the invention;
Figures 5a, 5b and 5c illustrate semiconductor devices according to embodiments of the invention

### DETAILED DESCRIPTION

A key feature of the present invention is to provide a further miniaturization of a semiconductor device by using a lead frame structure as an interconnect, so that a wire or a clip are not required for the interconnection. Furthermore, compared to a known chip scale package, such as DSN, the package according to the present invention is five-side protected and supports a higher power due to a vertical current flow.

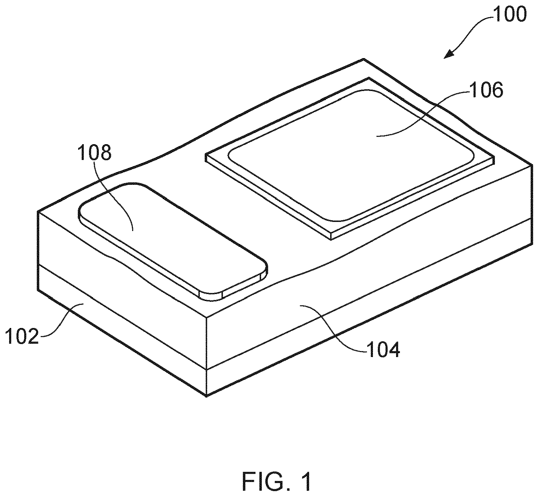

An embodiment of the present invention is shown in Figure 1. A semiconductor device 100 comprises a lead frame 102 which is also acting as a heatsink, an encapsulant 104 positioned on the top of the lead frame 102, and a die pad 106 and a metal pad 108, the die pad 106 and the metal pad 108 positioned on the top of the encapsulant 104.

In this embodiment a lead frame structure 102 of the semiconductor device 100 is used as an interconnect. Therefore, the semiconductor device does not use a wire or a clip for the interconnection.

As shown in Figure 1, front-side contacts on the top of the semiconductor device 100 are the die pad 106 and the metal pad 108. The metal pad 108 is a part of the lead frame structure 102 through which the metal pad 108 is connected to the back side of the die, so that an additional interconnect such as a wire bond or a clip is not required. Such an interconnect method supports a vertical current flow of the die. The dimensions of the metal pad 108 are designed to support a transient thermal shock.

A top heat sink is formed by the exposed lead frame after singulation. The heat sink enhances thermal performance of the package of the semiconductor device.

The lead frame is encapsulated on one surface of lead frame only, using a dispensing technology. The die is protected from five 5 sides.

According to an embodiment of the present invention, a method of manufacturing a semiconductor device comprises steps:
- attaching a die,
- dispensing,
- deflash, and
- singulate.

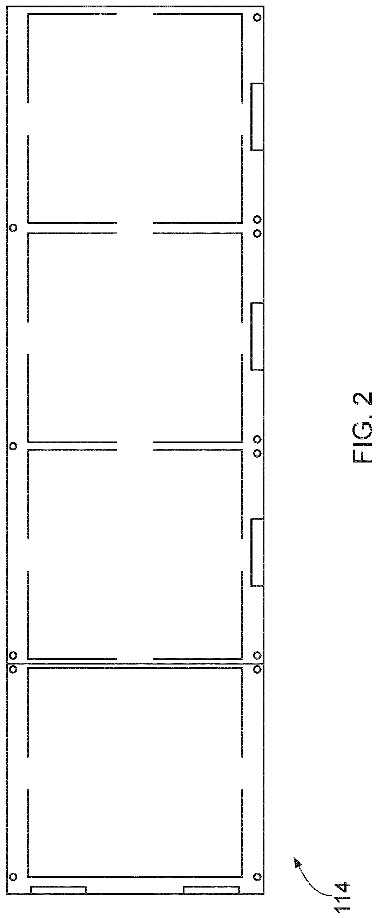

According to an embodiment of the present invention shown in Figure 2, a lead frame 114 is separated in several blocks, in this particular example the lead frame is separated in four blocks. This can be applied in a QFN/DFN lead frame design. The lead frame structure is formed by typical etching process in a lead frame fabrication. To facilitate encapsulation without tape, the etching is applied on only one surface of the lead frame within each block, so that no encapsulant will flow to the other surface of lead frame during later encapsulation process. A die can be attached by appropriate die attach methods such as a conductive die attach film, silver epoxy or sintering. Each block is then encapsulated to the same height level of the contact pads using dispensing. A deflash process may be included so to remove any encapsulant flash on contact pad surfaces. As the lead frame is pre-plated with appropriate surface finish, such as NiPdAu, further plating process is not needed. Finally, the units are singulated using typical dicing process.

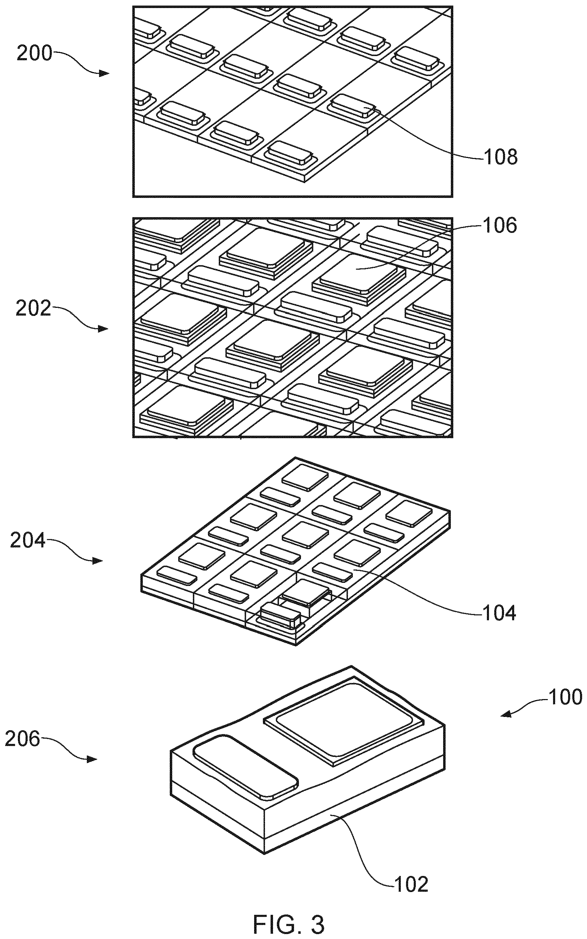

According to an embodiment of the present invention shown in Figure 3, a method of manufacturing of a semiconductor device comprises following steps:
- reference number 200: forming a metal pad 108 structure on a top side of a lead frame 102;
- reference number 202: attaching a die pad 106 via a die attach material to the lead frame;
- reference number 204: dispensing an encapsulant 104 on the top of the lead frame 102; and
- reference number 206: singulate a package of a semiconductor device 100

The package of the semiconductor device created in this way has terminals made of lead frame structure and exposed die pad.

The lead frame structure forms an integral role of package terminal and the connection to the die pad. Thus, no additional wire bonding or clip bonding is required.

At the same time, the semiconductor device created in this way has a top heat sink on opposite surface to terminals, which is also an integral part of the lead frame structure. Compared to a typical power QFN known in the art, the typical power QFN provides a bottom center pad only and requires additional heat slug attach process in case a top heat sink is desired.

According to an embodiment of the present invention, the dispensing is used for encapsulation on the top surface of the lead frame. By dispensing, the terminals height alignment between the metal pad and the die pad can be easier realized. Molding will require tight pad height alignment, or an additional die pad metallization thickness is required for subsequent grinding process to remove a mold flash. Compared to conventional power QFN packages known in the art, the molding is used to encapsulate on both surfaces of the lead frame and a tape, or a film is required in order to achieve the height alignment, thus the process is much more complicated.

The packages created according to the embodiments of the present invention can be used for various semiconductor devices, for example power DFN packages for vertical devices, typically diodes. However, it can be also applied for any other applicable semiconductor devices, e.g. a MOSFET device, a bipolar transistor device, devices with more than 3 inputs/outputs (I/O), etc.

According to an embodiment of the present invention an alternate design of lead frame can be used, e.g. differential etching on both sides of the lead frame, so that a new package outline can be created with a different heat sink profile.

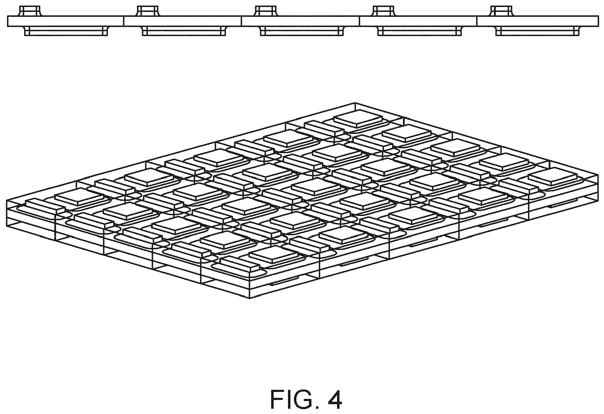

This embodiment of the present invention is shown in Figure 4. The lead frame is etched on another side of the lead frame, opposite to a metal pad, so to create a new, additional heat sink structure or to enhance saw singulation.

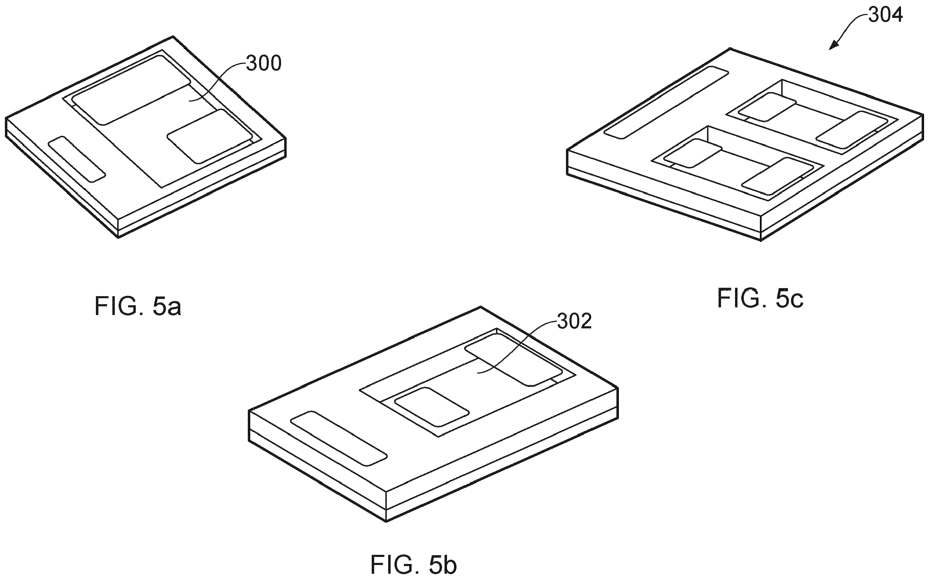

The above described embodiments are not limited to the presented examples. For example, the embodiments of the invention are also applicable to vertical semiconductor devices with 2 die pads, such that a power DFN can be a 3-terminal package. Some exemplary embodiments of the present invention are shown in Figures 5a, 5b and 5c.

An embodiment of the present inventions presented in Figure 5a shows a semiconductor device that is a MOSFET transistor device 300.

An embodiment of the present inventions presented in Figure 5b shows a semiconductor device that is a bipolar transistor device 302.

An embodiment of the present inventions presented in Figure 5c shows a semiconductor device 304 with more than three multi I/Os.

Particular and preferred aspects of the invention are set out in the accompanying independent claims. Combinations of features from the dependent and/or independent claims may be combined as appropriate and not merely as set out in the claims.

The scope of the present disclosure includes any novel feature or combination of features disclosed therein either explicitly or implicitly or any generalisation thereof irrespective of whether or not it relates to the claimed invention or mitigate against any or all of the problems addressed by the present invention. The applicant hereby gives notice that new claims may be formulated to such features during prosecution of this application or of any such further application derived therefrom. In particular, with reference to the appended claims, features from dependent claims may be combined with those of the independent claims and features from respective independent claims may be combined in any appropriate manner and not merely in specific combinations enumerated in the claims.

Features which are described in the context of separate embodiments may also be provided in combination in a single embodiment. Conversely, various features which are, for brevity, described in the context of a single embodiment, may also be provided separately or in any suitable sub combination.

Term "comprising" does not exclude other elements or steps, the term "a" or "an" does not exclude a plurality. Reference signs in the claims shall not be construed as limiting the scope of the claims.

## Claims

1. A semiconductor device comprising:
- a lead frame,
- a metal pad, wherein the metal pad is connected to a back side of the semiconductor device via the lead frame,
- a die pad, wherein the die pad is attached to the lead frame via a die attach material, and
- an encapsulant disposed on the top surface of the lead frame, wherein the encapsulant isolates the metal pad from the die pad.

2. A semiconductor device as claimed in claim 1, wherein the lead frame acts as a heat sink.

3. A semiconductor device as claimed in any of the previous claims, wherein the lead frame is pre-plated with an appropriate surface finish, such as NiPdAu.

4. A semiconductor device as claimed in any of the previous claims, wherein the die attach material is a conductive die attach film, a silver epoxy or a sintering material.

5. A semiconductor device as claimed in any of the previous claims, wherein the semiconductor device is a diode, or a MOSFET transistor, or a bipolar transistor, or a semiconductor device with more than three I/Os.

6. A method of producing a semiconductor device, wherein the method comprises steps:
- forming a metal pad on a top side of a lead frame;
- attaching a die pad via a die attach material to the lead frame;
- dispensing an encapsulant on the top of the lead frame, wherein the encapsulant isolates the metal pad from the die pad; and
- singulating a semiconductor device.

7. A method of producing a semiconductor device as claimed in claim 6, wherein the method further comprises a step of deflash so to remove the encapsulant from the metal pad and from the die pad.
